# EUROPEAN PATENT APPLICATION

(11) **EP 3 113 223 A1**
(43) Date of publication of application: **04.01.2017**
(21) Application number: 15175025.4
(22) Date of filing: 02.07.2015
(51) Int. Cl.: H01L 25/07, H01L 25/18, H01L 23/00

(54) **POWER SEMICONDUCTOR MODULE**

(71) Applicant: ABB Technology AG, 8050 Zürich (CH)
(72) Inventor: Traub, Felix, 4310 Rheinfelden (CH); Schuderer, Jürgen, 8047 Zürich (CH); Hartmann, Samuel, 5603 Staufen (CH); Kicin, Slavo, 8049 Zürich (CH); Skibin, Stanislav, 5415 Nussbaumen (CH)
(74) Representative: ABB Patent Attorneys

(57) **Abstract**

The present invention relates to a power semiconductor module, comprising a first substrate (12) having a first substrate metallization (16), a second substrate (18), having a second substrate metallization (22) and a third substrate (24) having a third substrate metallization (28), wherein the power semiconductor module (10) further comprises a plurality of power semiconductor devices (30) electrically connected to the first substrate metallization (16), the second substrate metallization (22) and the third substrate metallization (28), wherein at least two of the power semiconductor devices comprise a power semiconductor switch, wherein the plurality of power semiconductor devices (30) is positioned on the first substrate metallization (16), wherein the first substrate metallization (16) is aligned in a first plane (46), the second substrate metallization (22) is aligned in a second plane (48) and the third substrate metallization (28) is aligned in a third plane (50), wherein the second plane (48) is located between the first plane (46) and the third plane (50) in a direction normal to the second plane (48), and wherein the first substrate metallization (16) is adapted for carrying a first electrical potential, the second substrate metallization (22) is adapted for carrying a second electrical potential and the third substrate metallization (28) is adapted for carrying a third electrical potential, wherein the first, the second and the third electrical potential are different compared to one another. Such a power semiconductor module (10) allows an easy paralleling of a plurality of power semiconductor devices (30), is producible with known techniques and/or may work with low stray inductance.

## Description

### Technical Field

The Invention relates to a power semiconductor module. In particular, the invention relates to a power semiconductor module which may show a defined arrangement of different substrates there by allowing a decreased stray inductance, very flexible routing of power currents and sensor signals in modules with many paralleled chips and high current capability and thus an improved working behaviour.

### Background Art

In conventional semiconductor power electronics half-bridge modules, a significant part of the commutation loop is formed in the plane of a ceramic substrate.

Such a conventional module package may provide good performance for chips based on silicon as semiconductor, wide bandgap- (WBG-) semiconductors, however, require considerably improved switching performance of the module. In this context first hybrid and full wide bandgap modules available on the market are generally only pioneering packaging for WBG-semiconductors.

However, there have already been presented several promising packaging concepts. These concepts are trying to optimize electromagnetic interference (EMI) and electromagnetic compatibility (EMC) by low strain inductance (Lσ) module design focusing on optimization of the loop size including power terminals loop contribution. A typical approach is a compact-flat package.

Such a concept is inter alia described in the publications T. Gottwald, C. Roessle: Increasing packaging density and thermal performance with minimized parasitics for high powerinverters, PCIM Europe 2012, 8-10 May 2012, Nuremberg, Germany; K. Weidner, M. Kaspar: Planar interconnect technology for power module system integration, CIPS 2012, 6-8 March 2012, Nuremberg, Germany; M. Mermet-Guyennet, A. Castellazzi, J. Fabre, P. Ladoux: Electrical analysis and packaging solutions for high-current fast-switching SiC components, CIPS 2012, 6-8 March 2012, Nuremberg, Germany; M. Horio, Y. lizuka, Y. Ikeda, E. Mochizuki, Y. Takahashi: Ultra compact and high reliable SiC MOSFET power module with 200° C operating capability, ISPDS 2012, 3-7 June 2012, Bruges, Belgium; C.M. Johnson, A. Castellazzi, R. Skuriat, P. Evans, Li Jianfeng, P. Agyakwa: Integrated high powermodules, CIPS 2012, 6-8 March 2012, Nuremberg, Germany; Zhenxian Liang, Puqi Ning, F. Wang, L. Marlino: Reducing Parasitic Electrical Parameters with a Planar Interconnection Packaging Structure, CIPS 2012, 6-8 March 2012, Nuremberg, Germany; and in E. Hoene, A. Ostmann, B.T. Lai, C. Marczok, A. Musing, J.W. Kolar: Ultra-low-inductance power module for fast switching semiconductors, PCI M Europe 2013, 14-16 May 2013, Nuremberg, Germany.

These modules are not always compatible with current used power electronics system solutions and they are often not supported by existing production lines. Apart from that, their reliability, power scaling possibilities and operating temperature capability are often not clear. Thus, such solutions still have potential for improvements.

Suppression of the module commutation loop in the plane of the substrate (x-y) and formation of this loop preferably in the y-z plane is another promising approach from the point of the fast switching high current/high power power electronics module. This is shown in G. Borghoff: Implementation oflow inductive strip line concept for symmetric switching in a new high power module, PCIM Europe 2013, 14-16 May 2013, Nuremberg, Germany. Additional necessary but realistic goals of this approach are balanced gate-emitter loop coupling and module manufacturability by conventional package assembling technologies. In order to achieve these goals the chips are paralleled in lines parallel to each other and pads of power terminals and terminals themselves have same parallel configuration.

M. Meisser, D. Hamilton, T. Blank, P. Mawby: Low-inductive compact SiC power modules for high-frequency operation, PCIM Europe 2014, Nuremberg, Germany, further describes the design, manufacture and electrical characteristisation of full-SiC half-bridge modules suited for high frequency operation. The modules consist of stacked AIN DCB substrates equipped with SiC MOSFETs and SiC JFETs. According to this document, the commutation loop is mainly in the plane parallel to the substrates.

Zheng Chen: Electrical Integration of SiC Power Devices for High-Power-Density Applications, Dissertation submitted to the faculty of the Virginia Polytechnic Institute and State University, September 26, 2013, Blacksburg, Virginia, describes a single-chip SiC JFET module having stacked copper layers with insulators there between.

US 2011/0216561 A1 describes a similar concept of module packaging. In detail, according to this document, a power semiconductor assembly includes at least two bridge branches each including at least two circuit breakers connected to a phase output. Each of the circuit breakers has at least two parallel-connected switching elements integrated into a semiconductor chip. Each of the circuit breakers is arranged in a power semiconductor module and the individual power semiconductor modules are arranged adjacent to one another in a first direction. The semiconductor chips of a particular circuit breaker are arranged adjacent to one another in the corresponding power semiconductor module in a second direction extending perpendicular to the first direction.

Thus, published half-bridge packaging concepts which use a 3D concept are indicating very good switching performance but their implementation in power electronic applications and their manufacturing technologies are not ideal.

Further, the half-bridge concepts based on the paralleling of chip lines allows to improve switching performance of the conventional silicon based power electronic module package but it is not ideal for small-area wide bandgap switches especially if one wants to achieve higher module current rating.

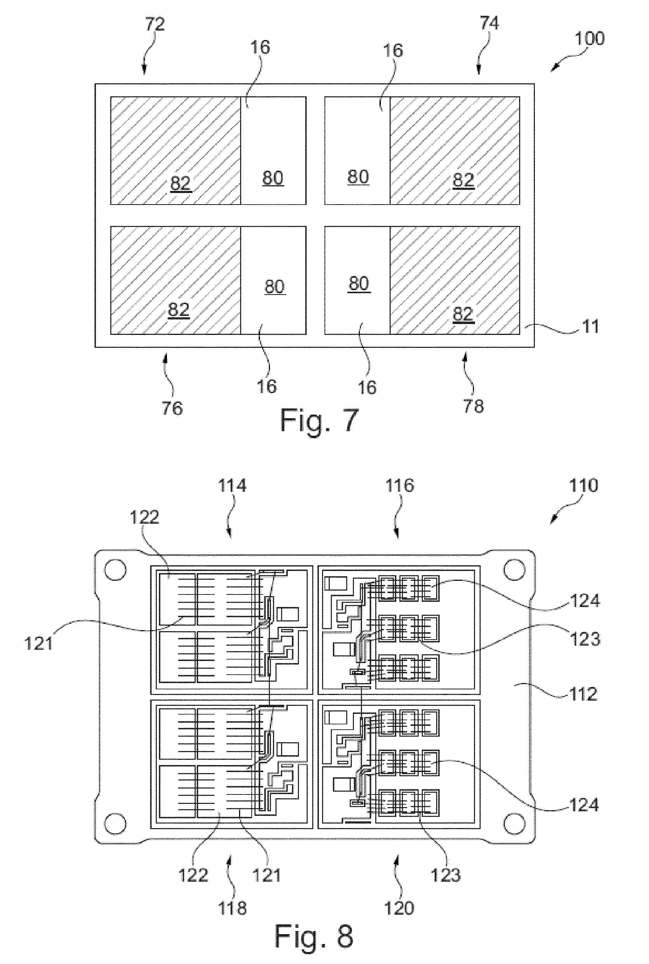

This is shown in figure 8 in which a power semiconductor module 110 according to the prior art is shown which is formed in a half-bridge configuration. In detail, the lower side of the half-bridge module is based on silicon devices, whereas the upper side of the half-bridge is based on silicon carbide-based devices. Four sub-modules 114, 116, 118, 120 are shown located on a baseplate 112, wherein the sub-modules 114, 118 are provided with silicon based power semiconductor devices 122 which are respectively connected by bond wires 121. In case such a configuration should be equipped with wide bandgap semiconductor-based devices 124, like shown in sub-modules 116, 120, this leads to a high complex wiring of bond wires 123 and further to comparably low current rating.

Therefore, there is, still potential for improvements for power semiconductor modules.

### Summary of invention

It is therefore an object of the present invention to provide an improved power semiconductor module which shall obviate at least one of the disadvantages known in the art.

In particular, it is an object of the present invention to provide a power semiconductor module which provides the possibility of working with a low stray inductance and balanced current sharing and further which may be manufactured easily and/or with known techniques under the provision that paralleling a plurality of chips may be possible.

These objects are at least partly achieved by a power semiconductor sub-module according to claim 1. These objects are further at least partly achieved by a power semiconductor module according to claim 13. Preferred embodiments of the present invention are defined in the dependent claims.

The invention relates to a power semiconductor sub-module, comprising a first substrate having a first substrate metallization, a second substrate, having a second substrate metallization and a third substrate having a third substrate metallization, wherein the power semiconductor sub-module further comprises a plurality of power semiconductor devices electrically connected to the first substrate metallization, the second substrate metallization and the third substrate metallization, wherein at least two of the power semiconductor devices comprise a power semiconductor switch wherein the plurality of power semiconductor devices is positioned on the first substrate metallization, wherein the first substrate metallization is aligned in a first plane, the second substrate metallization is aligned in a second plane and the third substrate metallization is aligned in a third plane, wherein the second plane is located between the first plane and the third plane in a direction normal to the second plane, and wherein the first substrate metallization is adapted for carrying a first electrical potential, the second substrate metallization is adapted for carrying a second electrical potential and the third substrate metallization is adapted for carrying a third electrical potential, wherein the first, the second and the third electrical potential are different compared to one another.

A power semiconductor sub-module according to the invention shall particularly mean a building block and thus such an arrangement, which may be used for forming a full power semiconductor module. In other words, a plurality of sub-modules may be used for forming a module because of which a power semiconductor module comprises a plurality of power semiconductor sub-modules.

Such a power semiconductor sub-module may work with reduced stray inductance and balanced current sharing, may be formed with conventional packaging materials and techniques and/or may further allow a controlled packaging of a plurality of power semiconductor devices providing high current capability.

The power semiconductor sub-module comprises a first substrate having a first substrate metallization, a second substrate, having a second substrate metallization and a third substrate having a third substrate metallization. Therefore, the power semiconductor sub-module comprises at least three substrates. At least one or each of the substrates may comprise a substrate main body, such as a ceramic structure, and at least one substrate metallization especially on their top side. The main body may be formed from aluminium nitride (AIN), alumina (AIO) or silicon nitride (SiN), for example, whereas the metallization may be formed from copper or aluminum, for example.

It is not excluded from the present invention that at least one substrate is formed differently than described above or that the first, the second and the third substrates are formed differently compared to each other. For example, the third substrate may be formed very thin and thus thinner compared to the first and the second substrate since the voltage there is only few tens of volts, depending on the specific arrangement. However, the substrates may generally be formed as it is known in the art.

Further, the power semiconductor sub-module comprises a plurality of power semiconductor devices. Such power semiconductor devices may be generally formed as it is known in the art and may comprise, inter alia, transistors, or switches, respectively, such as MOSFETs and/or IGBTs and/or the plurality of power semiconductor devices may comprise diodes. The power semiconductor devices comprise at least two switches. The power semiconductor devices may be respectively interconnected and may thus be in electrical contact, such as in galvanic contact with the first substrate metallization, the second substrate metallization and the third substrate metallization. This may at least partly be realized, for example, by a direct contact of a contact of the power semiconductor devices with the respective metallization, or by using wire bonds, for example.

It is further provided that the plurality of power semiconductor devices is positioned on the first substrate metallization. In particular, it may be provided that each of the power semiconductor devices arranged in said power semiconductor sub-module is positioned on the first substrate, or first substrate metallization, respectively.

Regarding the position of the first substrate, the second substrate and the third substrate, according to the power semiconductor sub-module as described, the first substrate metallization is aligned in a first plane, the second substrate metallization is aligned in a second plane and the third substrate metallization is aligned in a third plane, wherein the second plane is located between the first plane and the third plane in a direction normal to the second plane. Advantageously, the first plane, the second plane and the third plane are aligned parallel to each other and are thus spaced apart from one another in a direction normal to the first plane and the second plane and the third plane.

Regarding the interconnection of the power semiconductor devices with the respective substrate metallizations, it is further provided that the first substrate metallization is adapted for carrying a first electrical potential, the second substrate metallization is adapted for carrying a second electrical potential and the third substrate metallization is adapted for carrying a third electrical potential, wherein the first, the second and the third electrical potential are different compared to one another. In other words, the respective substrate metallizations are electrically insulated from each other and are respectively connected to contacts of the power semiconductor devices such, that each metallization may carry a different electrical potential particularly of the respective contacts of the power semiconductor devices.

Therefore, each of the substrates, or substrate metallizations, respectively, in the multilayer is connected to a different potential present in the sub-module. Each relevant potential of the plurality of power semiconductor devices and thereby especially of at least two, such as of at least four, power semiconductor switches, in the sub-module is thus distributed exploiting different metallic layers in the substrate structure. In reality, it means that there may be one layer for "plus" (typically bottom substrate), one layer for "minus" (typically middle substrate) and one layer for gate signal (typically top substrate). In particular, one potential may be collector (drain) potential, one potential may be emitter (source) potential and one potential may be gate potential wherein these potentials are distributed to all power semiconductor devices in the power semiconductor module without compromises, which are according to the prior art typical for conventional power modules, like described down below. However, such an arrangement particularly allows high current carrying capability and further well balanced current.

The substrates and particularly the second and the third substrate can be formed of one piece or it may comprise smaller sub-substrates which are electrically interconnected by a suitable technology, such as wire bonding, ribbon, soldered conductive part and more.

Further, the second substrate can, next to a one part form, be made of several parts and some of them can be interconnected using the bottom metallization of the third substrate in which a kind of bridge structure may be used.

Apart from that, although three-level substrate structure is advantageous for the distribution of potentials to the power semiconductor devices, a part of the electrical circuit on the substrate can be realized using only one or two levels. For example, main and/or auxiliary terminals can be connected only to the bottom substrate. The multilayer structure is than connected to the terminal bonding areas by suitable technique; e.g., wire bonding.

Apart from the above, the three layer structure as described before can be assembled before the power semiconductor devices are bonded, simultaneously therewith or afterwards. The multilayer substrate can be sintered, solder, brazed, there can be used adhesives or TLP processes etc. The whole multilayer structure can be assembled using one technology or combine them.

Paralleling of substrates may be used to increase current rating of a half-bridge module which may be formed from a plurality of sub-modules. The power semiconductor devices on the substrates and the multilayer structure can be same or different. For example wide bandgap chips, such as SiC chips can be on one substrate and silicon based chips, such as IGBTs, may be located on a further substrate in order to achieve targeted performance of the module and e.g. price targets.

A power semiconductor sub-module as described has a plurality of advantages especially over the solutions according to the prior art. In fact, a very advantageous arrangement for the internal structure of power electronic modules being equipped with said sub-modules, such as for power electronic half-bridge modules is presented, which may prevent or at least reduce known problems of paralleling a plurality of power semiconductor devices, or chips, respectively, especially in fast switching power semiconductor modules.

In detail, due to the fact that the power semiconductor devices are located on the first substrate metallization and all substrate metallizations are adapted to carry a different electrical potential, an advantageous and easy to form interconnection of even a large number of power semiconductor devices may be achieved. Especially, it is not required to form a complex arrangement of a plurality of bond wires to different positions, for example. In contrast thereto, the respective contacts of the power semiconductor devices may be combined with the respective metallizations in a very straight forward manner.

In fact, by using techniques according to the prior art, it is mostly difficult to apply these concepts for connecting and paralleling a plurality of chips in order to produce high current modules which provide high current capability. Especially, providing module bond wires which proceed from one power semiconductor device to a further semiconductor device may be difficult especially for a gate connection according to the prior art in case a large number of power semiconductor devices is provided.

The formation of high current modules by paralleling a plurality of chips is, however, not problematic due to the straight-forward connection of the contacts of each power semiconductor device with the respective metallization in said power semiconductor sub-module.

The semiconductor devices can be bonded at any position of the bottom substrate, narrow channels with complicated routes are not necessary. This allows that accessibility is not limited by other necessary electrical connections, such as gate connection, emitter / source connection.

It is allowed to define main and auxiliary terminals attaching positions at "any" desired place on the substrate, or in other words, the positioning is very flexible and it fits to various shapes of the sub-module and thus the whole module. One can thus easier design low inductive power terminals.

Apart from that, due to the fact that the substrate metallizations are aligned each in a plane which planes are spaced apart one from the other, it is in a large amount possible to use and exploit a three-dimensional structure of interconnections within the sub-module which is achieved due to the described multilayer structure of substrates, or substrate metallizations, respectively.

According to the present power semiconductor sub-module, it becomes possible to keep the commutation loop in a large amount in a plane perpendicular to the substrates and thus in a plane being advantageously perpendicular to the first plane, the second plane and the third plane. Therefore, the commutation loop in the plane of the substrates and thus for example parallel to the first plane, the second plane and the third plane is strongly reduced.It may be determined by the thickness of the substrates, particularly of the second substrate and for example by the used bond wire loops of the power devices, wherein the contribution of the terminals is not taken into account.

Multi-layer substrate structure allows reducing the stray inductance Lσ, of both power and gate loops, which in turn significantly improves the working behavior of the power module.

A power semiconductor sub-module as described thus allows high flexibility of the layout design requiring paralleling of many semiconductor chips, such as of small area semiconductors. More exactly it allows very flexible routing of power currents and sensor signals. In particular, by stacking current paths, it is no longer necessary to "cut" conducting planes or narrow lines to accommodate current return or gate signal paths. This allows for example good dynamic and static current sharing and low stray inductance und thus improved working behaviour.

Well balanced and low gate coupling results in good current sharing. The power semiconductor devices are further not stressed, such as overheated, for example by locally higher current. This allows improving the reliability of the power module. It is further allowing a solution for an improved gate connection of many (typically small area) chips required by rating of the module.

The concept flexibility further allows easily combining chips of different sizes, such as exemplarily silicon based IGBTs, silicon carbide based MOSFETS and diodes and further. Therefore, especially having a large number of devices having different sizes and forms, is possible according to the present invention without significant problems.

Apart from the above, due to the fact that the power semiconductor devices are located on the first substrate metallization, the thermal management of the devices and thus of the module is very effective. This may be especially the truth, in case the first substrate is provided on a cooling device. This allows effectively cooling the power devices which strongly improves the reliability and further the lifetime of the module.

With this regard, the cooling device may be an active cooling device and may as thus be actively cooled, such as by a water cooling. Alternatively, the cooling device may be a passive cooling device, which serves for guiding heat generated in the power semiconductor devices away from these devices. Regarding the latter, the cooling device may be a baseplate. Even though the main object of the baseplate may be to provide a mechanical support, due to the fact that the baseplate at least to some extends guides heat away from the power semiconductor devices, such an element may as well be called a cooling device, in particular in case it is connected to a heat sink, for example.

Regarding the manufacturability of such a power semiconductor sub-module, all necessary technologies and materials are available in the existing production lines. This may result in an attractive price of the sub-module and thus as well module price. Additionally, the proposed concept can be seen as an allowing technology bringing many cost benefits of system level. Apart from that, the formation of a power semiconductor sub-module may be integrated into existing production lines without problems. Further, the often complex formation of narrow conductive paths often necessary for formation of the electrical circuit in the conventional modules according to the prior art are minimized or not present in the substrate metallization.

Assembly technologies are standard for module packaging and the additional substrate levels can be often bonded in the same step as semiconductor devices, which allows producing such modules at low prices.

The concept is suitable for higher current and voltage ratings (at least several 100 A and 1.2 kV) and it is scalable. Further, the present sub-module may be especially advantageous for half-bridge modules, but is in no way restricted thereto.

To summarize, a power semiconductor sub-module as described above allows at least one of an improved and flexible package of a large plurality of parallelized power semiconductor devices having fast switching capability thereby allowing known production techniques and low stray inductance and balanced current sharing. In particular, all of a low stray inductance, balanced current sharing and paralleling of many power semiconductor devices may be allowed.

According to an embodiment, it may be provided that a plurality of at least 4 power semiconductor devices is provided on the first substrate metallization and thus in one sub-module. In detail, the specific number of the power semiconductor devices depend on the specific form of the devices. When providing silicon-based devices, for example, a number of at least 4, such as of at least 6 devices may be present on each first substrate-metallization and, in this way, may be comprised by a sub-module.

When providing silicon-based devices, for example, a number of at least 4 devices may be present on each first substrate-metallization and thus may be comprised by a sub-module. Silicon based half-bridge modules comprising such sub-modules may than comprise 16 devices. When providing wide bandgap semiconductor-based devices, such as silicon carbide-based devices, for example, a number of at least 6, and typically many more, such as of at least 9 devices may be present on each first substrate-metallization and thus may be comprised by a sub-module. Therefore, when equipping a power module with such sub-modules for example for forming a half-bridge-module, in total, the module may comprise 24 and more power semiconductor devices. However, especially in case a half-bridge module comprises both conventional semiconductor devices, such as silicon based devices, and additionally wide bandgap semiconductor based devices, the number of the devices in a half-bridge modules may vary as it is clear for the person skilled in the art.

According to this embodiment, the power semiconductor module comprises a comparably large number of power semiconductor devices which are located on the first substrate metallization and which preferably are connected to each other in parallel. Especially according to this embodiment, the power semiconductor sub-module is advantageous as especially by providing a large number of power semiconductor devices, the arrangement and connection of these devices may be especially easy and straight-forward according to the present invention which is essentially not possible according to the prior art.

Apart from that, by using such a number of power semiconductor devices, a high current module as well as a high voltage rating may be realized, for example when forming a half-bridge module, which is only possible in state of the art modules mainly by comparably complex wiring and connection methods.

According to a further embodiment, it may be provided that at least one power semiconductor device is based on a wide bandgap semiconductor. Exemplarily, at least one of the switches is based on a wide bandgap semiconductor. Especially, it may be provided that a plurality or all power semiconductor chips are provided on wide bandgap semiconductors.

Especially with regard to wide bandgap semiconductors, the stray inductance should be decreased in order to maintain a good switching behaviour. Therefore, the power semiconductor module as described above is especially advantageous for such wide bandgap semiconductors being present in the power semiconductor transistors. Such semiconductor devices are based for example on silicon carbide (SiC) or gallium nitride (GaN). As an explanation but without being limited thereto, "wide" bandgap semiconductors typically refer to a material with a band gap of at least three eV. Such a band gap is significantly greater than these of the commonly used semiconductors, such as silicon (1.1 eV) or gallium arsenide (1.4 eV).

Especially packages for fast switching semiconductors, for example for the emerging SiC market, have to have low stray inductance which can handle short switching times, or improved switching performance, respectively, which will be will be especially critical for the packages designed for e.g. SiC devices. Therefore, the module arrangement as described above is especially advantageous for wide bandgap semiconductors.

Further, small size of semiconductor chips is very typical for wide bandgap-devices in order to reach reasonable yield and costs. It means it may be necessary to place from 3 to 5 times more chips into the module to achieve the same current rating as in silicon based modules, for example. Assuming the same size of the sub-modules and same number of substrates in the module, one may place and connect 3-5 times more chips on one substrate in wide bandgap power modules. This fact is making power module design with fast switching capability even more challenging for wide bandgap modules than in the case of silicon based modules, for example. According to the present invention, however, this may be realized without significant problems due to the straight-forward packaging opportunities and thus the possible paralleling of a plurality of power semiconductor devices, or chips, respectively and particularly a plurality of at least two power semiconductor switches.

Most-likely, it would be beneficial to have the same module shape (standard) for both silicon based modules and modules based on wide bandgap semiconductors. However, as a further issue related to packaging of wide bandgap semiconductors devices, the latter have considerably smaller current rating and current size compared to silicon devices. Therefore direct replacement of silicon devices by small area WBG-semiconductors is not always a straight forward approach since it requires solutions allowing to connect gates of many more chips and simultaneously to connect their top metallization (emitter, source etc.) in order to achieve similar current rating as in the Si-module version. According to the present invention, however, this is not problematic. In contrast thereto, more wiring complexity and related performance disadvantages may be prevented.

Regarding current rating, smaller silicon carbide chip size further again requires adding of more paralleled chip lines in order to achieve similar module current rating as in silicon based modules, for example. This generally results in more complex wiring in wide bandgap modules. Especially for this embodiment, however, complex wiring may be prevented according to the present invention.

According to this embodiment of the present invention, it is possible to package in the "standard" power module housing while still achieving high performance of wide bandgap semiconductor modules, which in turn allows a direct replacement of silicon based modules, for example, by wide bandgap semiconductor based modules.

According to a further embodiment, the power semiconductor devices are arranged in one or more rows on the first substrate. In particular, the power semiconductor devices, or chips, respectively, are organized in two or more parallel lines, which may oriented in x or y direction of the substrate. The x-and y direction thereby are aligned perpendicular to each other and aligned in one plane, which may be parallel to the first plane. The power devices may be placed, such as bonded at a large area bottom metallization, for example. This approach allows to placing large amount of small chips on the substrate. It is further possible to provide necessary electrical connections without performance degradation of the module, such as switching deterioration, performance losses, cooling problems or deteriorations with regard to power density.

The above advantages may additionally be realized especially effectively in case, which is possible in every embodiment, the dimension of the first substrate metallization in the first plane is larger compared to the dimension of the second substrate and the third substrate parallel to the first plane especially in case these planes are arranged parallel to each other. With this regard, the first substrate metallization may have a device area for positioning the power semiconductor devices and it may have a substrate area for placing the second substrate, these areas being located next to each other in the first plane. This allows an easy and clear positioning of both power devices and subsequent substrates. This feature may be realized especially advantageously in case the arrangement of the chips in defined lines is realized as described before.

In fact, it becomes possible especially easily to connect the power devices with the respective substrates, or substrate metallizations, respectively. The second substrate and third substrate parts may be distributed in parallel to the chip lines and allow "deliver" potential/current to each chip.

Each relevant potential in the module is distributed to the power devices exploiting different metallic and thus conductive layers in the multilayer structure especially straight forward and without or with insignificantly deteriorating the performance.

According to a further embodiment, it may be provided that the first substrate, the second substrate and the third substrate are stacked one onto the other. In other words, it may be provided that the second substrate is provided directly on the first substrate and that the third substrate is located directly on the second substrate. This allows providing a sandwich structure of the substrates which allows further advantages. In detail, the commutation loop which is particularly provided in a plane perpendicular to the first, second and third plane, is essentially only dependent on the thickness of the substrates. This allows forming the commutation loop very exactly and thus to provide the stray inductance in a very defined manner. Therefore, the working behaviour of the power semiconductor module may as well be formed in a very defined manner.

Further, such a sandwich structure allows forming the power module in a very straight-forward manner essentially without complex substrate structures. This further allows simplifying the manufacturing method and thus allows a cost-saving production of the respective power semiconductor module.

According to a further embodiment, at least one of the first substrate, the second substrate and the third substrate comprises a ceramic main body and at least one, preferably two metallizations formed from copper or from aluminium. For example, at least one of the first substrate, the second substrate and the third substrate may be formed as a direct bonded copper (DBC) substrate or as an Active Metal Brazed (AMB) substrate. Such substrates generally comprise a ceramic main body, such as formed from alumina, which comprises a copper layer (DBC substrate) or aluminium (AMB substrate) as metallization bonded to one or both sides of the main layer for example by means of a high-temperature oxidation process or by a brazing process.

The advantage of using DBC substrates or AMB substrates may be, for example, a good thermal conductivity regarding the first substrate. Therefore, thermal management of the module may be further improved. Apart from that, especially in case substrate metallizations, i.e. copper layers or aluminium , are provided on both sides of the main layer and thus particularly of the ceramic base layer, especially stacking of the substrates may be improved due to the fact that metallic layers may be fixated to metallic layers. Such fixation processes may be realized without problems and with known processes.

According to a further embodiment, at least one of the first substrate, the second substrate and the third substrate comprises a polymeric material equipped with a metallization. For example, the third substrate may comprise a polymeric material, such as from a material which is known for printed circuit boards, such as epoxy materials, or by polyimides, such as the one which is known under its name Capton from the firm DuPont. This embodiment realizes bringing a lot of design flexibility and further has sufficient electrical insulation with respect to the substrate metallization above or below. Apart from that, polymeric materials may be applied in a very cost-saving manner which additionally holds the cost of the whole sub-module low. Further, a comparably low thickness of said substrate may be achieved which is sufficient for the third substrate like described down below.

According to a further embodiment, the first plane, the second plane and the third plane are arranged parallel to each other. It may further be provided that direction normal to the first plane and the second plane is in a range of ≥ 0,1 mm to ≤ 3mm, such as of ≥ 0,3mm to ≤ 2mm, for example 1 mm. Alternatively or additionally, it may be provided that the distance between the second plane and the third plane normal to the second plane and the third plane is in a range of ≥ 0,1 mm to ≤ 1,5mm, such as of ≥ 0,15mm to ≤ 0,4mm, for example 0,2mm, wherein the distance may be determined by the thickness of the insulation layers between the respective metallization carrying the respective electrical potential and thus of the respective ceramic main bodies, for example.

In fact, generally, when talking about the planes, the exact location of these layers may be chosen in an appropriate manner. For example, the plane may go through the middle part of the metallization. However, especially when talking about the distances of the respective planes laying above each other in case the planes are aligned horizontally, it may especially the case that the plane lies in the most upper section of the lower metallization and the most lower section of the upper metallization and vice versa. In other words, the above distances may advantageously refer to the minimum distances between to planes going through the respective metallizations.

According to this embodiment, the commutation loop can be formed especially significantly in the plane perpendicular to the first, the second and the third plane. This allows reducing stray inductance and thus improving the working behaviour especially effectively. Such distances may be adjusted, for example, by adjusting the thickness of the substrates. Thereby, especially defined distances may be achieved in combination with an easy manufacturing method. The distance between the second and the third plane may be comparably low as this insulation has to only act against gate voltages.

According to further technical features and advantages of the sub-module as described, it is referred to the description of the power semiconductor module, the figures and the description of the figures.

The present invention further relates to a power semiconductor module, the power semiconductor module comprising a plurality of sub-modules as described before. The plurality of sub-modules may be arranged on a plurality of supports, or they may be located on one common support, such as on a baseplate, for example.

Preferably, the sub-modules are provided on a cooler.

With this regard, the cooler, or cooling device, respectively, may be an active cooling device and may as thus be actively cooled, such as by a water cooling. Alternatively, the cooling device may be a passive cooling device, which serves for guiding heat generated in the power semiconductor devices away from these devices. Regarding the latter, the cooling device may be a baseplate. Even though the main object of the baseplate may be to provide a mechanical support, due to the fact that the baseplate at least to some extends guides heat away from the power semiconductor devices, such an element may as well be called a cooling device, in particular in case it is connected to a heat sink, for example.

The plurality of sub-modules may be provided on one common cooler, such as on a common baseplate, or a plurality of coolers, such as baseplates, is provided. For example, the power semiconductor module may comprise two, four or even more than four sub-modules.

It may be especially preferred that the power semiconductor module is configured to work as a half-bridge module. Such a configuration is generally well known in the art and is thus not described here in detail.

A power semiconductor module as described here provides the advantages of at least one of reduced stray inductance, balanced current sharing and high current capability by paralleling a plurality of chips. In particular, the power semiconductor module may provide all of the afore-named advantages.

According to further technical features and advantages of the power semiconductor module described, it is referred to the description of the sub-module, the figures and the description of the figures.

### Brief description of drawings

Additional features, characteristics and advantages of the subject-matter of the invention are disclosed in the subclaims, the figures and the following description of the respective figures and examples, which -in an exemplary fashion- show one embodiment and example of a semiconductor module according to the invention.

In the figures:
Figure 1 shows a sectional side view of an embodiment of a power semiconductor sub-module according to the invention;
Figure 2 shows a view onto a full half-bridge module comprising four sub-modules according to the invention;
Figure 3 shows a view on a further simplified embodiment of a sub-module according to the invention;
Figure 4 shows a view on a further simplified embodiment of a sub-module according to the invention;
Figure 5 shows a view on a further simplified embodiment of a sub-module according to the invention;
Figure 6 shows a view on a further simplified embodiment of a sub-module according to the invention;
Figure 7 shows a schematic top view onto a power semiconductor module having four sub-modules according to the invention; and
Figure 8 shows a power semiconductor module according to the prior art.

### Description of embodiments

In the figures, embodiments of power semiconductor modules 100 and of sub-modules being provided in said modules 100 according to the present invention are shown. These power semiconductor modules 100 were studied using Ansys Q3D software with focus on module stray inductance and gate coupling. All of them show very low stray inductance (from 1 to 3nH without power terminals) and from very good to excellent gate coupling. In detail, gate coupling was always negative, low and balanced.

According to the following figures, the same or comparable parts are essentially provided with the same numerals.

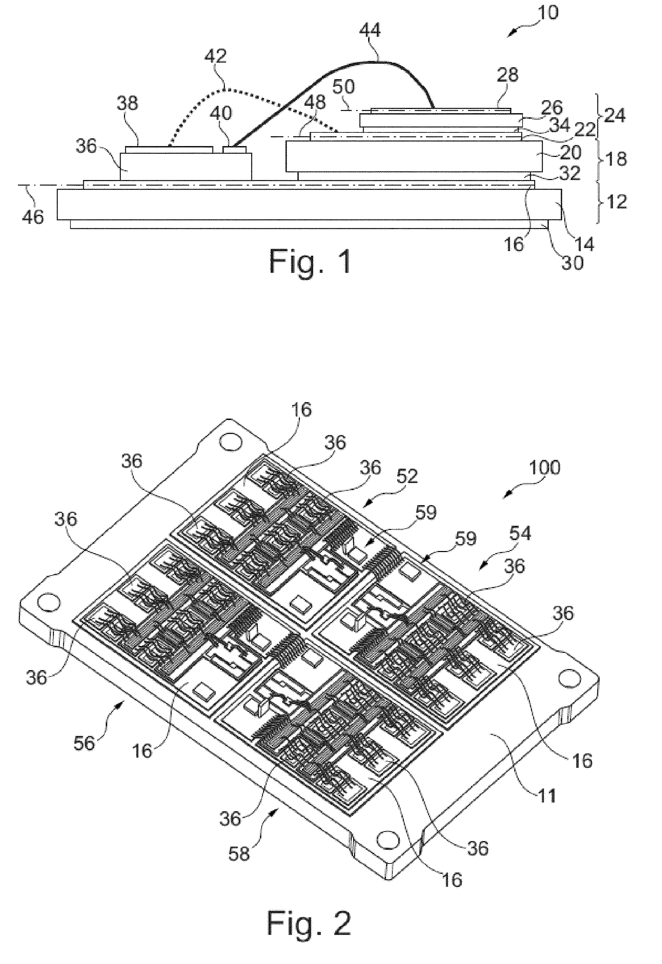

In figure 1, an embodiment of the power semiconductor sub-module 10 according to the invention is schematically shown. The power semiconductor sub-module 10 comprises a first substrate 12 having a first main body 14 and a first substrate metallization 16, a second substrate 18 having a second main body 20 and a second substrate metallization 22 and a third substrate 24 having a third main body 26 and a third substrate metallization 28. In detail, each of the first substrate 12, the second substrate 18 and the third substrate 24 are formed as direct bonded copper substrates with a ceramic main body 14, 20, 26 and, next to said metallizations 16, 22, 28, which may be formed from copper, having bottom metallizations 30, 32, 34. The power semiconductor sub-module 10 further comprises a plurality of power semiconductor devices 36 being positioned on the first substrate metallization 16 and being electrically connected to the first substrate metallization 16, the second substrate metallization 22 and the third substrate metallization 28.

In detail, the power semiconductor devices 36 are electrically connected to the first substrate metallization 16 by directly positioning them and thus their contacts, such as their drain/collector contact, on the first substrate metallization 16. The power semiconductor devices 36 are further connected to the second substrate metallization 22 and third substrate metallization 28 via their source/emitter contact 38 and their gate contacts 40 and via wire bonds 42, 44.

It can further be seen that the first substrate metallization 16 is aligned in a first plane 46, the second substrate metallization 22 is aligned in a second plane 48 and the third substrate metallization 28 is aligned in a third plane 50, wherein the second plane 48 is located between the first plane 16 and the third plane 50 in a direction normal to the second plane 48, wherein the first plane 46 and the second plane 48 and the third plane 50 are arranged parallel to each other. This is realized in that the substrates 12, 18, 24 are stacked one onto the other.

It can further be seen that the dimension of the first substrate metallization 16 is larger compared to the dimension of the second substrate 18 and the third substrate 24. Therefore, positioning the power semiconductor devices 30 next to the second substrate 18 and third substrate 24 is straight forward and not problematic.

According to the embodiment of figure 1, the first substrate metallization 16 is adapted for carrying a first electrical potential, the second substrate metallization 22 is adapted for carrying a second electrical potential and the third substrate metallization 28 is adapted for carrying a third electrical potential, wherein the first, the second and the third electrical potential are different compared to one another.

Figure 2 shows an example of a half-bridge module 100 based on four sub-modules 52, 54, 56, 58 as described in figure 1. The sub-modules 52, 54, 56, 58 are located on and bonded to a baseplate 11. This approach allowed to place nine power semiconductor devices 36 forming a module switch cell on one substrate 12 and achieve low module stray inductance and well balanced gate coupling. It can be seen that the power semiconductor devices 36 are arranged in one or more rows on the first substrate metallization 16.

It can further be seen from figure 2, that a part of the electrical circuit on the substrate 12 can be realized using only one or two levels. For example, main and/or auxiliary terminals can be connected only to the first substrate 12, wherein only the terminal feet 59 are shown. The multilayer structure is than connected to the terminal bonding areas by suitable technique; e.g., wire bonding.

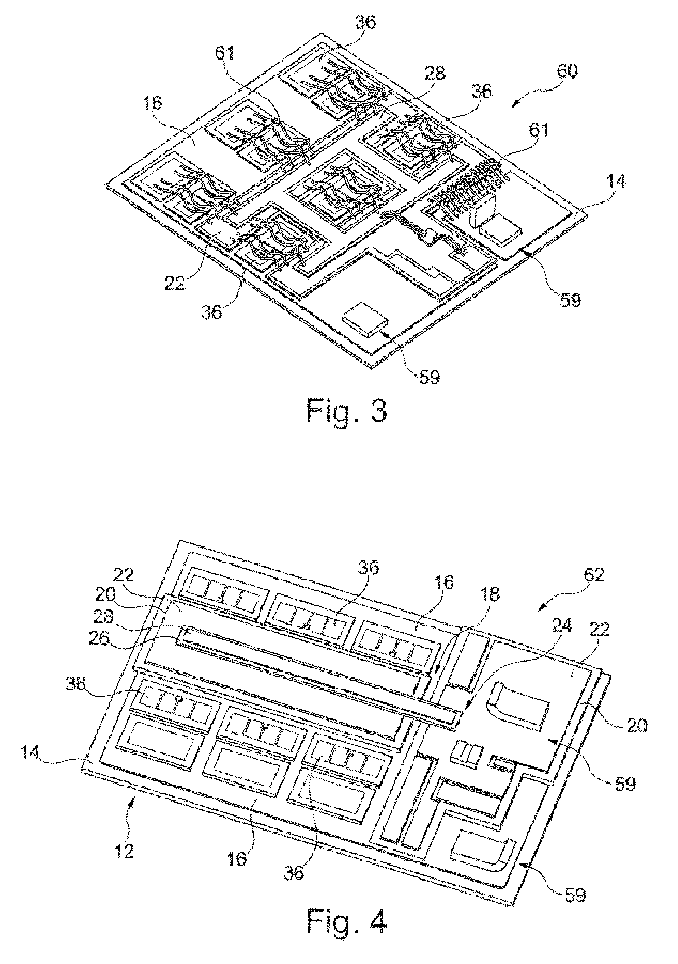

A more detailed view of a sub-module 60 similar to sub-module 54 of the arrangement of figure 2 can be seen in figure 3.

A module switch as sub-module 60 shown in Fig. 3 is based on only three substrates forming a multilayer sandwich structure. In detail, again, the first substrate metallization 16, second substrate metallization 22 and third substrate metallization 28 are shown wherein power semiconductor devices 36 are located on the first substrate metallization 16. Respective electrical connections are formed by means of bond wires 61, wherein for simplifying the figure, each wire bonds 61 have the same numeral. This embodiment is simplifying the module assembly process and provides excellent module performance and an excellent switching performance.

Fig. 4 shows a further embodiment of a sub-module 62 which shows, compared to the embodiment of figure 3, improved producability. In detail, according to figure 4, most of the parts have standard rectangular shape which might be advantageous with regard to production processes. Therefore, independent of the specific embodiment, it may be advantageous that a plurality of substrates 12, 18, 24 have rectangular shape. Although the tree layer arrangement is still an important feature of this embodiment, a part of the structure has two layers, only, to simplify the substrate sandwich structure. The substrates 12, 18, and 24 shown in this figure are significantly less complex and the number of the substrates was not dramatically increased. The embodiments of Fig. 4 as well as the one of figure 3, for example, also show that the multilayer concept allows different x-y orientation of semiconductor rows in the plane of the substrate.

It has to be noted that electrical connections such as wire bonds are omitted in this figure for clarity reasons.

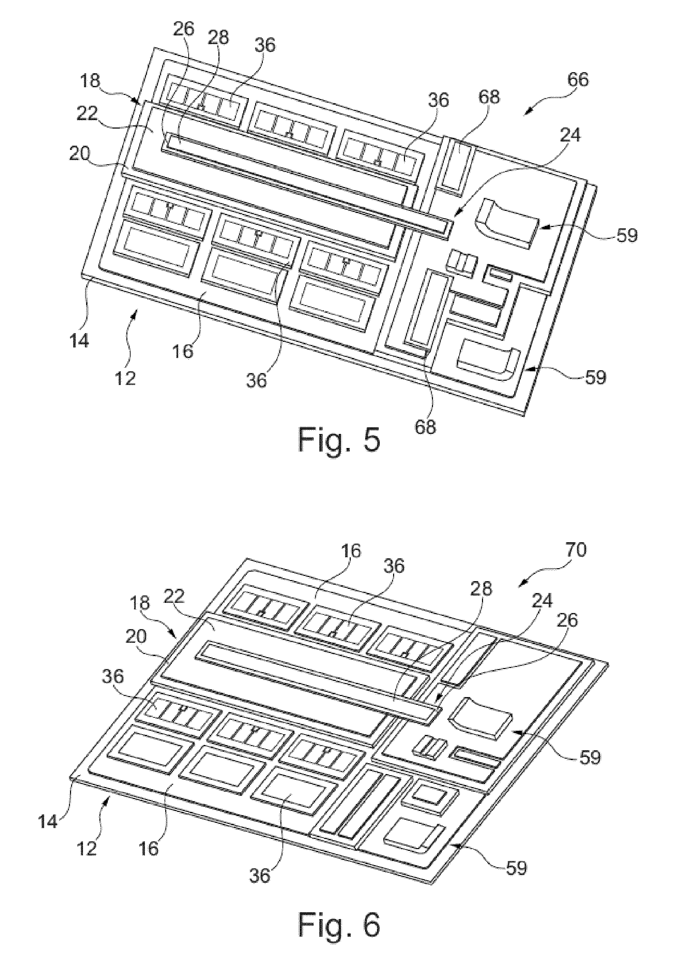

Figure 5 shows a further embodiment of a sub-module 66. The layout in Fig. 5 is basically the same as the one shown in Fig. 4; however, in order to achieve maximum performance from the point of gate coupling, the gate electrical circuit is more strictly designed in the 3^{rd} substrate level, i.e. on the third substrate metallization 28, or forming the latter, respectively. For allowing comparably easy production processes, again, most of the parts have standard rectangular shape. However, compared to Fig. 4, there were added the third level gate sub-substrates 68. Therefore, it might be preferred independent of the respective embodiment to provide a substrate as third substrate level which is a gate substrate 68 and which is isolated parallel to the third plane 50. This embodiment allows improved tuning of gate coupling in order to achieve desired switching performance.

Again, it has to be noted that electrical connections such as wire bonds are omitted in this figure for clarity reasons.

Figure 6 shows a further embodiment of a sub unit 70. The layout according to figure 6 is based on only rectangular parts forming the targeted multilayer sandwich structure. This approach is slightly increasing number of assembled parts, such as for the substrates forming second and third level electrical circuit. However, it is decreasing their costs and fabrication complexity. Although a three-layer arrangement is still important, a part of the structure has only two different levels. Improved switching performance can be achieved in a similar way as shown in Fig. 5 by adding additional parts forming gate electrical circuit in the third layer.

Further, the second substrate 18 can, next to a one part form, be made of several parts and some of them can be interconnected using the bottom metallization 34 of the third substrate 24 in which a kind of bridge structure may be used. This is shown in figures 4 to 6 and may be realized independently of the respective embodiment.

Figure 7 shows a simplified top view onto a half-bridge module 100 having upper switches on the left side and lower switches on the right side having high current rating. In detail, the baseplate 11 may be seen, on which four sub-modules 72, 74, 76, 78 are located, each sub-module 72, 74, 76, 78 being based on a three-level substrate structure as described before.

The embodiment of figure 7 comprises at least one substrate of upper switch and one substrate of lower switch. It is shown in a simplified manner that each sub-module 72, 74, 76, 78 comprises a substrate region 82 at which the multilayer structures like described above are provided and a terminal region 80 at which power and auxiliary terminal connections are provided.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- 10: power semiconductor sub-module
- 11: baseplate
- 12: first substrate
- 14: first main body
- 16: first metallization
- 18: second substrate
- 20: second main body
- 22: second metallization
- 24: third substrate
- 26: third main body
- 28: third metallization
- 30: first bottom metallization
- 32: second bottom metallization
- 34: third bottom metallization
- 36: power semiconductor device
- 38: source/emitter contact
- 40: gate contact
- 42: wire bond
- 44: wire bond
- 46: first plane
- 48: second plane
- 50: third plane
- 52: sub-module
- 54: sub-module
- 56: sub-module
- 58: sub-module
- 59: terminal feet
- 60: sub-module
- 61: bond wire
- 62: sub-module
- 66: sub-module
- 68: gate substrate
- 70: sub-module
- 72: sub-module
- 74: sub-module
- 76: sub-module
- 78: sub-module
- 80: terminal region
- 82: substrate region
- 100: power semiconductor module
- 110: power semiconductor module
- 112: baseplate
- 114: sub-module
- 116: sub-module
- 118: sub-module
- 120: sub-module
- 121: bond wire
- 122: power semiconductor device
- 123: bond wire
- 124: power semiconductor device

## Claims

1. Power semiconductor sub-module, comprising a first substrate (12) having a first substrate metallization (16), a second substrate (18), having a second substrate metallization (22) and a third substrate (24) having a third substrate metallization (28), wherein the power semiconductor sub-module (10) further comprises a plurality of power semiconductor devices (36) electrically connected to the first substrate metallization (16), the second substrate metallization (22) and the third substrate metallization (28), wherein at least two of the power semiconductor devices comprise a power semiconductor switch, wherein the plurality of power semiconductor devices (36) is positioned on the first substrate metallization (16), wherein the first substrate metallization (16) is aligned in a first plane (46), the second substrate metallization (22) is aligned in a second plane (48) and the third substrate metallization (28) is aligned in a third plane (50), wherein the second plane (48) is located between the first plane (46) and the third plane (50) in a direction normal to the second plane (48), and wherein the first substrate metallization (16) is adapted for carrying a first electrical potential, the second substrate metallization (22) is adapted for carrying a second electrical potential and the third substrate metallization (28) is adapted for carrying a third electrical potential, wherein the first, the second and the third electrical potential are different compared to one another.

2. Power semiconductor sub-module according to claim 1, wherein a plurality of at least four power semiconductor devices (36) is provided on the first substrate metallization (16).

3. Power semiconductor sub-module according to claim 1 or 2, wherein at least one power semiconductor device (36) is based on a wide bandgap semiconductor.

4. Power semiconductor sub-module according to any of the preceding claims, wherein the power semiconductor devices (36) are arranged in one or more rows on the first substrate (16).

5. Power semiconductor sub-module according to any of the preceding claims, wherein the dimension of the first substrate metallization (16) in the first plane (46) is larger compared to the dimension of the second substrate (18) and the third substrate (24) parallel to the first plane (46).

6. Power semiconductor sub-module according to any of the preceding claims, wherein the first substrate (12), the second substrate (18) and the third substrate (24) are stacked on onto the other.

7. Power semiconductor sub-module according to any of the preceding claims, wherein at least one of the first substrate (12), the second substrate (18) and the third substrate (24) comprises a ceramic main body (14, 20, 26) and at least one, preferably two metallizations (16, 23, 28, 30, 32, 34) formed from copper or from aluminium.

8. Power semiconductor sub-module according to any of the preceding claims, wherein at least one of the first substrate (12), the second substrate (18) and the third substrate (24) comprises a polymeric material equipped with a metallization (16, 23, 28, 30, 32, 34).

9. Power semiconductor sub-module according to any of the preceding claims, wherein the first plane (46), the second plane (48) and the third plane (50) are arranged parallel to each other.

10. Power semiconductor sub-module according to claim 9, wherein the distance between the first plane (46) and the second plane (48) in a direction normal to the first plane (46) and the second plane (48) is in a range of ≥ 0,2mm to ≤ 3mm.

11. Power semiconductor sub-module according to claim 9 or 10, wherein the distance between the second plane (48) and the third plane (50) in a direction normal to the second plane (48) and the third plane (50) is in a range of ≥ 0,1 mm to ≤ 1,5 mm.

12. Power semiconductor sub-module according to any of the preceding claims, wherein the first substrate (12) located on a cooler.

13. Power semiconductor module, comprising a plurality of sub-modules (10) according to any of the preceding claims.

14. Power semiconductor module according to claim 13, wherein the power semiconductor module (100) comprises a cooler, wherein the first substrate is located on said cooler.

15. Power semiconductor module according to claim 13 or 14, wherein the power semiconductor module (100) is formed as a half-bridge module.
